Europäisches Patentamt

European Patent Office

Office européen des brevets

(11) Publication number: **0 152 702**
**B1**

# (12) EUROPEAN PATENT SPECIFICATION

(45) Date of publication of patent specification: **18.07.90**

(21) Application number: **84309110.9**

(22) Date of filing: **27.12.84**

(51) Int. Cl.⁵: **H 03 M 13/00, G 11 B 20/18 //**
**G06F11/10**

(54) Arithmetic circuit of finite field.

(30) Priority: **30.12.83 JP 248204/83**

(43) Date of publication of application:
**28.08.85 Bulletin 85/35**

(45) Publication of the grant of the patent:
**18.07.90 Bulletin 90/29**

(84) Designated Contracting States:
**DE FR GB NL**

(56) References cited:
EP-A-0 048 933      EP-A-0 096 165
EP-A-0 096 109      GB-A-2 050 014
EP-A-0 096 163      US-A-3 868 632

IBM JOURNAL OF RESEARCH AND
DEVELOPMENT, vol. 24, no. 1, January 1980,
pages 32-42, New York, US; A.M. PATEL: "Error
recovery scheme for the IBM 3850 mass storage
system"

(73) Proprietor: **SONY CORPORATION**
**7-35 Kitashinagawa 6-Chome Shinagawa-ku**
**Tokyo 141 (JP)**

(72) Inventor: **Shirota, Norishisa**
**c/o Sony Corporation 7-35 Kitashinagawa 6-**
**chome**
**Shinagawa-ku Tokyo (JP)**

(74) Representative: **Ayers, Martyn Lewis Stanley**
**et al**
**J.A. KEMP & CO. 14 South Square Gray's Inn**
**London, WC1R 5EU (GB)**

(56) References cited:
IBM TECHNICAL DISCLOSURE BULLETIN, vol.
25, no. 3A, August 1982, pages 1114-1116, New
York, US; K.A. BELSER et al.: "ECC system using
two related check matrices"

IBM TECHNICAL DISCLOSURE BULLETIN, vol.
23, no. 10, March 1981, pages 4597-4599, New
York, US; C.L. CHEN: "Parallel implementation
of double-error correction and triple-error
detection"

# EP 0 152 702 B1

**Description**

This invention relates to an arithmetic circuit of finite field applied to an encoder and a decoder of error correction code.

When digital video signal, digital audio signal and the like are recorded and reproduced adjacent code or Reed Solomon code is practically used as error correction code. Parity data (redundant data) is generated in an encoder of such error correction signal, and syndrome is generated from received word including the parity data in a decoder and error correction is executed using the syndrome. An arithmetic circuit of finite field is used as hardware of the parity generating circuit, the syndrome generating circuit and the error correction circuit. The finite field is a field of pm elements derived from irreducible polynomial of m-th order, and the case in p = 2 is important for the error correction code. Consequently, this invention is applied to the finite field in p = 2.

In conventional arithmetic circuit of finite field used in an encoder and a decoder, when multiplication of elements of the finite field is executed, for example, in the case of (αi, αj), αi is stored in ROM so as to obtain exponent i and αj is similarly stored in ROM so as to obtain exponent j, and an adder produces exponent (i+j) which is stored in ROM thereby conversion to i+j is executed. In operation of finite field GF($2^m$), addition (also subtraction) can be simply implemented using exclusive-OR gate, but as clearly seen from above-mentioned example, a number of ROMs and registers are required to execute multiplication or division and thereby the scale of the circuit is inevitably enlarged. Moreover, the conventional arithmetic circuit of finite field is constituted in exclusive hardware at every sort of polynomial or operation and therefore cannot be used for general purposes.

EP—A—0 096 109 discloses a prior art error correcting system in which a first input of data is converted in accordance with a generating polynomial and then multiplied with a second input. There is no provision for choosing the generating polynomial.

According to this invention there is provided an arithmetic circuit of finite field SF($2^m$) comprising:

converting means for converting a first input of m-bits, being a vector expression of elements of finite field GF($2^m$) into components of a matrix expression in accordance with a generating polynomial.

multiplication means for multiplying each said component with a second input of m-bits also being a vector of elements of the finite field GF($2^m$), thereby to obtain a multiplication output of said first and second inputs in the vector expression of the finite field GF($2^m$);

characterised in that said converting means includes at least one input for receiving input signals defining desired values of the coefficients of said generating polynomial; altering means to alter the mode of operation of said converting means in accordance with those input signals so that the generating polynomial has the desired coefficients; in that said converting means includes shift register means which comprises a plurality of sets of exclusive-OR gates which are connected in such manner that the outputs of the exclusive-OR gates in one set are respectively applied to one bit higher inputs of the exclusive-OR gates in the following set thereof, and that the MSB output of the exclusive-OR gates of the one set becomes the LSB input of the following set; in that said multiplying means comprises a plurality of AND gates in which each said component of matrix expression and each bit of said second input are supplied; and in that said altering means comprises further AND gates selectively connecting said MSB output of the exclusive OR gate of the one set to the remaining inputs of the exclusive-OR gates of the following set under control of said input signals to control the operation of said exclusive-OR gates thereby altering the generating polynomial of said converting means. The invention is applicable to the digital recording of the video and audio signals, to the recording and/or reproduction of any other data requiring such an arithmetic computation of the type provided by the circuit.

In the drawings:

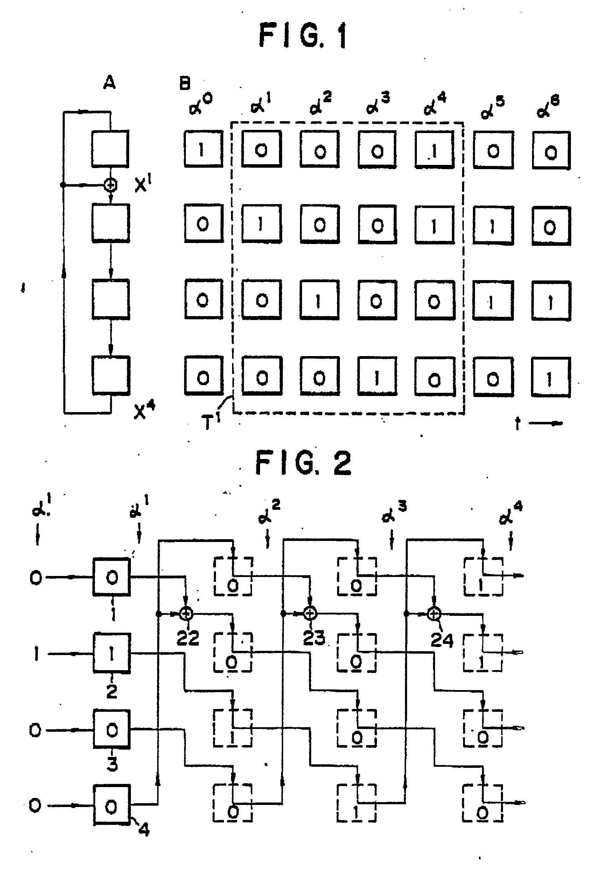

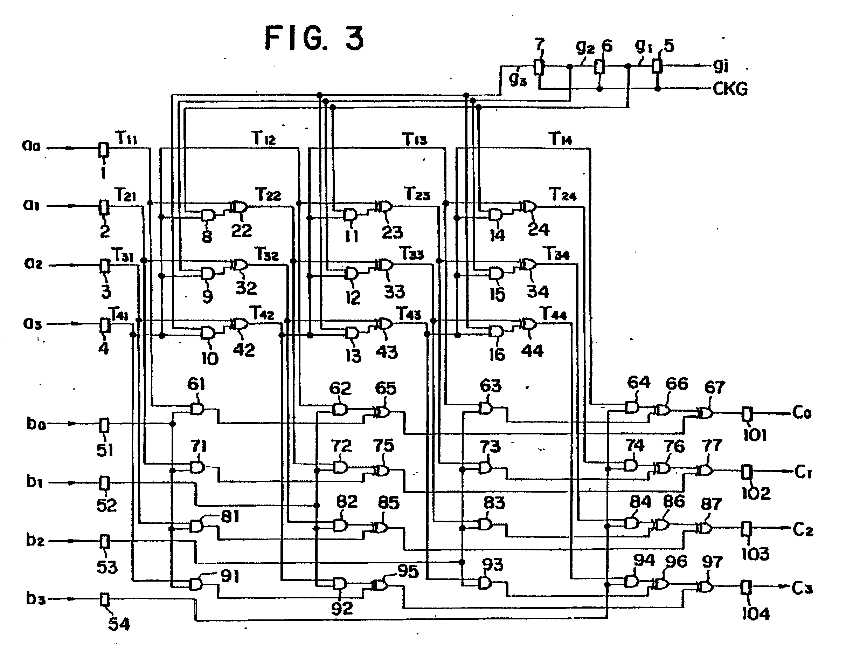

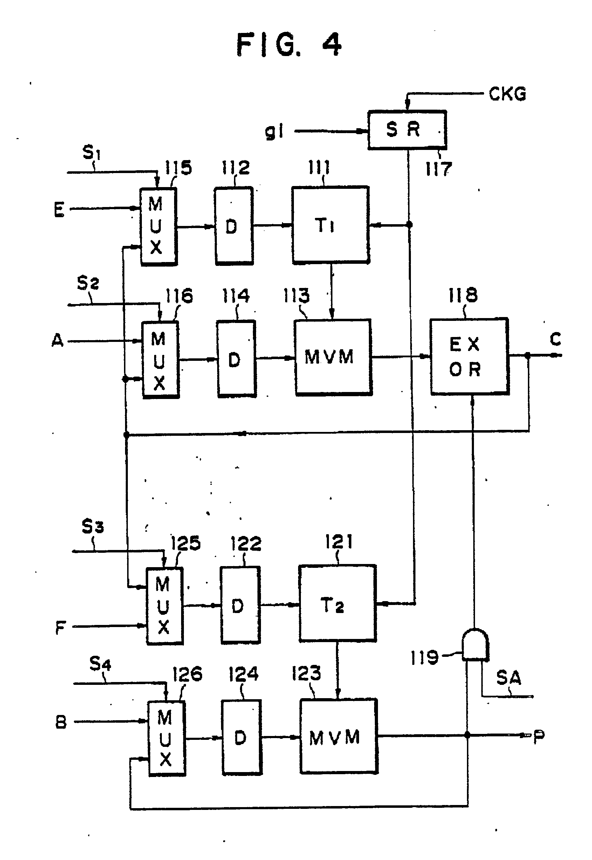

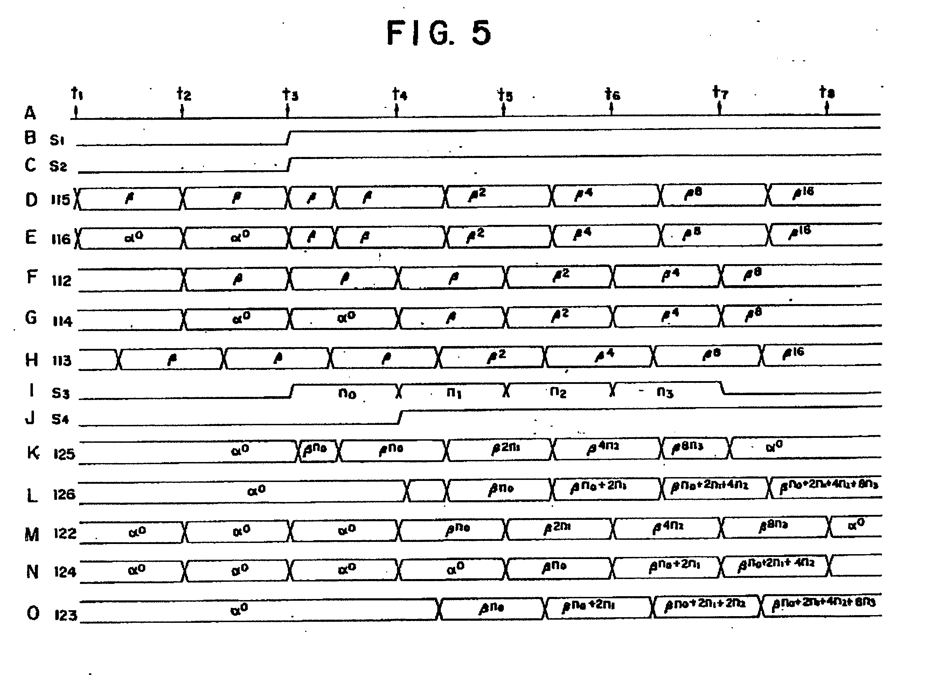

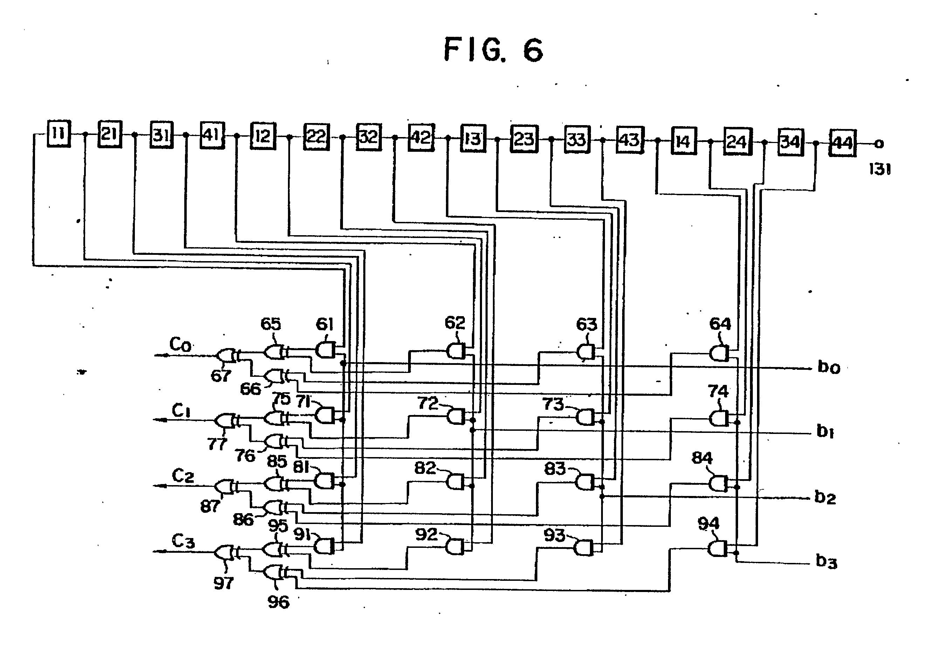

Figure 1 is a schematic diagram illustrating relation between elements on finite field and matrix expression; Figure 2 is a connection diagram of a converter to convert data of vector expression into components of matrix expression; Figure 3 is a connection diagram of an embodiment of the invention; Figure 4 is a block diagram of another embodiment of the invention; Figure 5 is a time chart illustrating operation of embodiment in Figure 4; and Figure 6 is a connection diagram of still another embodiment of the invention.

An embodiment of the invention will now be described regarding GF($2^m$) for the easy understanding.

First, relation between generator polynomial g(x) and element i on GF($2^m$) will be described. For example, assume that g(x) = x4+ x + 1. Coefficients of the generator polynomial g(x) in the power descending order may be written in (1, 0, 0, 1, 1). Corresponding to the coefficients, a shift register circuit having feedback loop can be constituted as shown in Figure 1(A). In Figure 1(A) an adder inserted between a register of the first stage and a register of the next stage is adder of (mod. 2).

If initial value (1000) is set to the shift register circuit as shown in Fig. 1(B) and then the shift operation is executed in sequence, content of each register varies as shown in Fig. (B). If root of g(x) = 0 is made α(=α1), α4 + α + 1 = 0 hence α4 = α + 1. Consequently, variation in the content of the registers shown in Fig. 1(B) is expressed in power of α as follows:

$$\alpha^0 \quad : \quad (1000) \qquad\qquad \alpha^8 \quad : \quad (1010)$$

$$\alpha^1 \quad : \quad (0100) \qquad\qquad \alpha^9 \quad : \quad (0101)$$

$$\alpha^2 \quad : \quad (0010) \qquad\qquad \alpha^{10} \quad : \quad (1110)$$

$$\alpha^3 \quad : \quad (0001) \qquad\qquad \alpha^{11} \quad : \quad (0111)$$

$$\alpha^4 \quad : \quad (1100) \qquad\qquad \alpha^{12} \quad : \quad (1111)$$

$$\alpha^5 \quad : \quad (0110) \qquad\qquad \alpha^{13} \quad : \quad (1011)$$

$$\alpha^6 \quad : \quad (0011) \qquad\qquad \alpha^{14} \quad : \quad (1001)$$

$$\alpha^7 \quad : \quad (1101) \qquad\qquad \alpha^{15} \quad : \quad (1000)$$

Elements $\alpha^4$ or more are expressed as linear combination of $\alpha^0$, $\alpha^1$, $\alpha^2$, $\alpha^3$ using equation ($\alpha^4 = \alpha + 1$). That is

$\alpha^4 = \alpha + 1$

$\alpha^5 = \alpha \cdot \alpha^4 = \alpha (\alpha + 1) = \alpha^2 + \alpha$

$\alpha^6 = \alpha^2 \cdot \alpha^4 = \alpha^2 (\alpha + 1) = \alpha^3 + \alpha^2$

$\alpha^8 = \alpha^1 \cdot \alpha^4 = (\alpha + 1)(\alpha + 1) = \alpha^2 + 1$

Thus expression of $\alpha^4$ or more using vector expression of $\alpha^0 - \alpha^3$ coincides with content shown in Fig. 1(B).

Next, a relation between $\alpha$ and matrix T will be described. If $g(x) = x^4 + x + 1$, adjoint matrix T becomes

$$T = \begin{pmatrix} 0 & 0 & 0 & 1 \\ 1 & 0 & 0 & 1 \\ 0 & 1 & 0 & 0 \\ 0 & 0 & 1 & 0 \end{pmatrix}$$

If $\alpha^i$ in Fig. 1(B) is column vector, it follows that $T = [\alpha^1, \alpha^2, \alpha^3, \alpha^4]$

Then $T^2$ becomes

$$T2 = T \times T = \begin{pmatrix} 0 & 0 & 1 & 0 \\ 0 & 0 & 1 & 1 \\ 1 & 0 & 0 & 1 \\ 0 & 1 & 0 & 0 \end{pmatrix}$$

Expressing $T^2$ using $\alpha^i$, it follows that $T^2 = [\alpha^2, \alpha^3, \alpha^4, \alpha^5)$. That is,

$$T^i = [\alpha^i, \alpha^{i+1}, \alpha^{i+2}, \alpha^{i+3}]$$

Wherein $i = 0, 1, 2, \ldots, 14$, and $i + 1$, $i + 2$, $i + 3$ may be estimated in (mod. 15). In other words, first row of $T^i$ is coincident with $\alpha^i$, vector expression of $\alpha$.

Next, expression $\alpha^i \times \alpha^j = \alpha^{i+j}$ will be described. Although vectors cannot be mutually multiplied, matrix can be multiplied with vector. Consequently, if the $\alpha^i$ is converted into the matrix expression Ti, the multiplication of $\alpha^i \times \alpha^j$ becomes possible. The multiplication of T with $\alpha$ is

$$T \cdot \alpha = \begin{pmatrix} 0 & 0 & 0 & 1 \\ 1 & 0 & 0 & 1 \\ 0 & 1 & 0 & 0 \\ 0 & 0 & 1 & 0 \end{pmatrix} \begin{pmatrix} 0 \\ 1 \\ 0 \\ 0 \end{pmatrix} = \begin{pmatrix} 0 \\ 0 \\ 1 \\ 0 \end{pmatrix} = \alpha^2$$

If $i = 2$ or more, it follows that

$$T \times \alpha^i = T \times \alpha \times \alpha^{i-1} = \alpha^2 \times \alpha^{i-1} = \alpha^{i+1}$$

It is understood generally that $T\alpha^i = \alpha^{i+1}$. Reversely from this relation, it follows that

$$\alpha^4 = T\alpha^3 = T^2\alpha^2 = T^3\alpha^1 = T^4\alpha^0$$

In general, expression $\alpha^{i+j} = T^i \cdot \alpha^j$ holds. As a result of the above relation, the $\alpha^i$ and the $T^i$ may be deemed identical in multiplication, and therefore in order to calculate the expression $\alpha^i \times \alpha^j$, the expression $T^i \times \alpha^j$ may be calculated.

Since the $T^i$ may be expressed in $T^i = [\alpha^i, \alpha^{i+1}, \alpha^{i+2}, \alpha^{i+3}]$ as above described, if other vector can be produced from $\alpha^i$, it follows that all components of the matrix $T^i$ be known. Consequently, by multiplying these components with the $\alpha^j$, the multiplication of ($\alpha^i \times \alpha^j$) can be executed.

Fig. 2 shows a circuit for converting $\alpha^1$ of vector expression into matrix expression $T^1$ wherein $g(x) = x^4+x+1$. Using the shift register circuit having feedback loop shown in Fig. 1(A), each register $\alpha^i$ is set and the shift operation is executed three times so as to generate $\alpha^{i+1}$, $\alpha^{i+2}$, $\alpha^{i+3}$ in sequence. Consequently, four registers 1, 2, 3, 4 in Fig. 2 are supplied with $\alpha^i$, say $\alpha^1$, from outside and by means of connection equivalent to the shift operation in three times components of the matrix $T^1$ can be generated simultaneously at output side of the four input registers and positions shown by broken line in Fig. 2. That is, the output side of the registers 1 through 4 is shifted downwards by one bit, and the most significant bit and the least significant bit are added by adders 22, 23, 24 of (mod. 2) at every shifting operation.

Fig. 3 shows a circuit construction showing an embodiment of the invention, wherein the inputs ai (a0, a1, a2, a3 from LSB) are supplied. Coefficients gi of generator polynomial g(x) are supplied to cascade connection of registers 5, 6, 7 and the coefficients $g_3$, $g_2$, $g_1$ are taken from the registers 5, 6, 7. If $g(x) = x^4 + x + 1$, it follows that $g_1 = 1$, $g_2 = g_3 = 0$. The coefficient $g_1$ is supplied to AND gates 8, 11, 14, the coefficient $g_2$ is to AND gates 9, 12, 15, and the coefficient $g_3$ is to AND gates 10, 13, 16.

Outputs of the AND gates 8, 9, 10 are supplied to exclusive-OR gates (hereinafter referred to as EXOR gates) 22, 32, 42 respectively at each one input of the EXOR gates. Outputs of the AND gates 11, 12, 13 are supplied to EXOR gates 23, 33, 43 respectively at each one input thereof. Outputs of the AND gates 14, 15, 16 are supplied to EXOR gates 24, 34, 44 respectively at each one input thereof. The respective set of the three AND gates in each line is commonly supplied with MSB in the previous line. The respective set of the three AND gates in each line always becomes 0 when the coefficient gi of the generator polynomial is 0, and the former supplies the feedback data to the EXOR gate when the coefficient gi is 1.

For example, when $g_1 = 1$ and $g_2 = g_3 = 0$, the EXOR gates 22, 23, 24 act as an adder of mod. 2 and other EXOR gates only make the state of the preceding AND gates pass as it is.

Consequently, the MSB in the previous line and outputs of the EXOR gates 22, 23, 24, ..., 44 constitute all components of matrix corresponding to the inputs $a_0$ through $a_3$. Elements ($b_0$, $b_1$, $b_2$, $b_3$) on other GB($2^m$) multiplied with the inputs converted into the matrix expression are written in registers 51, 52, 53, 54. Both are multiplied in

| T11 | T12 | T13 | T14 | $b_0$ |
|-----|-----|-----|-----|-------|
| T21 | T22 | T23 | T24 | $b_1$ |
| T31 | T32 | T33 | T34 | $b_2$ |
| T41 | T42 | T43 | T44 | $b_3$ |

and outputs c0, c1, c2, c3 of the multiplication becomes as follows:

$$c_o = T11\ b_o + T12\ b1 + T13\ b2 + T14\ b3$$

$$c1 = T21\ b_o + T22\ b1 + T23\ b2 + T24\ b3$$

$$c2 = T31\ b_o + T32\ b1 + T33\ b2 + T34\ b3$$

$$c3 = T41\ b_o + T42\ b1 + T43\ b2 + T44\ b3$$

Multiplication to generate the output co is executed by AND gates 61, 62, 63, 64, and addition is executed by EXOR gates 65, 66, 67, thereby output of the EXOR gate 67 is stored as co in a register 101.

The multiplication to generate the output c1 is executed by AND gates 71, 72, 73, 74, and the addition is executed by EXOR gates 75, 76, 77, thereby output of the EXOR gate 77 is stored as c1 in a register 102. Similarly, the output c2 formed by AND gates 81, 82, 83, 84 and EXOR gates 85, 86, 87 is stored in a register 103, and the output c3 formed by AND gates 91, 92, 93, 94 and EXOR gates 95, 96, 97 is stored in a register 104.

Thus the circuit shown in Fig. 3 can be used for multiplying the two elements of vector expression on the $GF(2^m)$ so as to generate a multiplied output and it is a very simple matter to change the generator polynomial $g(x)$.

In above-mentioned embodiment of the invention, assume that (a0, a1, a2, a3) be made input A, (b0, b1, b2, b3) be input B and (c0, c1, c2, c3) be output C. Then if $\alpha^N$ is supplied as A input, output C of $\alpha^N \cdot B$ is obtained. Wherein N is a value arbitrarily determined among $(0, 1, 2, \ldots, 2^m - 2)$, and $\alpha^N$ can be formed by supplying N as address of ROM to store a table. Similarly, $\alpha^N$ can be generated by other ROM so as to form output C of $\alpha^{-N} \cdot B$, and further $\alpha^{-i}$ can be generated by other ROM so as to form output C of $\alpha^{-i} \cdot B$.

Another embodiment of the invention shown in Fig. 4 is an arithmetic circuit where a multiplier shown in Fig. 3 is applied and such various operations as above described can be executed without using ROM.

In Fig. 4, reference numerals 111 and 121 designate converters to convert input data of vector expression into components of matrix T, and numerals 112 and 122 designate registers of m bits to store input of the converters 111 and 121. The converters 111 and 121 are supplied with coefficients of the creation polynominal from a shift register 117. The shift register 117 executes shift operation in response to clock CKG. Numerals 113 and 123 designate multiplication gates to execute matrix multiplication of components of the matrix T from the converters 111 and 121 with data of m bits in vector expression. The multiplication gates 113 and 123 are supplied with data of m bits from registers 114 and 124.

Input data to the register 112 is selected by a multiplexer 115 which is controlled by select signal $S_1$. Input data to the register 114 is selected by multiplexer 116 which is controlled by select signal $S_2$. Similarly, the registers 122 and 124 are supplied with data selected by multiplexers 125 and 126, respectively. The multiplexers 125 and 126 are controlled by select signals $S_3$ and $S_4$, respectively. Multiplication output of the multiplication gate 113 is supplied to EXOR gate 118; multiplication output of the multiplication gate 123 is supplied through AND gate 119 to the EXOR gate 118. The AND gate 119 is supplied with control signal SA, and if the control signal SA is 1, addition output of (mod. 2) from outputs of both multiplication gates 113 and 123 is taken as output signal C. If the control signal SA is 0, output of the multiplication gate 113 becomes output signal C.

The multiplexers 115, 116, 125, 126 are supplied with input data of m bits E, A, F, B respectively at each input of the multiplexers. The output data C is fed back as other input data of the multiplexers 115, 116, 125. Further, the multiplication output of the multiplication gate 123 is fed back as other input data of the multiplexer 126. The output data of the multiplication gate 123 is taken as output data P.

In the arithmetic circuit shown in Fig. 4, operation mode set by the select signals $S_1$—$S_4$ and the control signal SA will be described.

First, operation mode will be described when all select signals $S_1$, $S_2$, $S_3$, $S_4$ are 0 and the control signal SA is 1. Then the input data E, A, F, B are selected by the multiplexers 115, 116, 125, 126 respectively, and multiplication output of the multiplication gate 123 is supplied through the AND gate 119 to the EXOR gate 118. Consequently, if matrices of the converters 111 and 121 are designated by $T_1$ and $T_2$ respectively, output data C of $(C = T_1A + T_2B)$ is obtained. If the input data E and F are $\alpha^i$ and $\alpha^j$ respectively, it follows that $T_1 = T^i$, $T_2 = T^j$. Consequently, operation

$$C = T^i \cdot A + T^j \cdot B$$

can be executed. This operation is required in order to implement an error correction circuit.

Operation of $\beta^N$ as second example will be described. Since the number of power is usually given in binary notation, $GF(2^4)$ in m = 4 will be studied. Then the number of power N is expressed as follows:

$$N = n_o \cdot 2^o + n_1 \cdot 2^1 + n_2 \cdot 2^2 + n_3 \cdot 2^3$$

Consequently, operation of $\beta^N$ is executed as follows:

$$\beta^N = \beta^{N_o + 2n_1 + 4n_2 + 8n_3} = \beta^{n_o} \times \beta^{2n_1} \times \beta^{4n_2} \times \beta^{8n_3}$$

wherein $n_o$, $n_1$, $n_2$, $n_3$ are 0 or 1. Consequently, $\beta^2$, $\beta^4$, $\beta^8$ may be formed from giben $\beta$ and power operation be executed according to the number of power.

Procedure during the arithmetic operation of $\beta^N$ will be described referring to Fig. 5. Fig. 5(A) shows clocks of the arithmetic circuit, and the select signals $S_1$ and $S_2$ are 0 until the time $t_1$, $t_2$ as shown in Fig. 5(B) and Fig. 5(C). Data $\beta$ of four bits is entered as input data E, and $\alpha^o$ (=1000) is entered as input data A, F, B. The select signals $S_1$ and $S_2$ becomes 1 from time $t_3$ and calculation is started.

Input data $\beta$ and $\alpha^o$ are outputted from the multiplexer 115 and 116 as shown in Fig. 5(D) and Fig. 5(E), and these data are outputted from the registers 112 and 114 at delay of one clock as shown in Fig. 5(F) and Fig. 5(G). At time $t_3$, output of the register 112 becomes $\beta$ and output of the register 114 becomes $\alpha^o$. Since the control signal SA is 0 and output $\beta$ of the multiplication gate 113 is fed back through the multiplexer 115 and 116 to the registers 112 and 114, outputs of the registers 112 and 114 become $\beta$ at time $t_4$. The outputs of the registers 112 and 114 become $\beta^2$ at time $t_5$, and then vary to $\beta^4$, $\beta^6$, $\beta^8$. Fig. 5(H) shows output of the multiplication gate 113.

The output of the multiplication gate 113 is supplied through the EXOR gate 118 to the multiplexer 125. Select signal $S_3$ of the multiplexer 125 is changed per one clock corresponding to binary expression of exponent N ($n_o$, $n_1$, $n_2$, $n_3$) as shown in Fig. 5(I). If the select signal $S_3$ is 0, input data F (=$\alpha^o$) is selected; if the select signal $S_3$ is 1, output data of the multiplication gate 113 is selected. Consequently, output of the multiplexer 125 becomes $\beta^{n_o}$, $\beta^{2n_1}$, $\beta^{4n_2}$, $\beta^{8n_3}$ in sequence as shown in Fig. 5(K), and output of the register 122 becomes the output of the multiplexer 125 in delay of one clock as shown in Fig. 5(M).

Select signal $S_4$ becomes 1 at time $t_4$ as shown in Fig. 5(J), and output of the multiplication gate 123 is selected from input data B (=$\alpha^o$) after time $t_4$. Fig. 5(L) shows output of the multiplexer 126, and the output of the multiplexer 126 is taken in the register 124 which produces output shown in Fig. 5(N). At time $t_4$, $\beta^{n_o}$ from the register 122 and $\alpha^o$ from the register 124 are supplied to the multiplication gate 123, thereby output data P of ($\alpha^o \times \beta^{n_o} = \beta^{n_o}$) shown in Fig. 5(O) is generated. At time $t_5$, since input to the multiplication gate 123 becomes $\beta^{2n_1}$ and $\beta^{n_o}$, output P of the multiplication gate 123 becomes $\beta^{n_o+2n_1}$. Similarly, corresponding to input supplied to the multiplication gate 123 at time $t_6$, $t_7$, output P of $\beta^{n_o+2n_1+4n_2+8n_3}$ is obtained from the multiplication gate 123. Although not shown, the output data P is passed through a register thereby synchronized with the clock and value $\beta^8$ is outputted at time $t_8$.

Operation mode of $\beta^{-1}$ will be described as third example. In finite field of GF($2^4$), since arbitrary element $\beta$ other than 0 is $\beta^{15} = 1$ it follows that $\beta^{-1} = \beta^{14}$.

That is, N may be made (N = 14) and if N = (0111) is inputted as select signal $S_3$, $\beta^{-1}$ is outputted as output data P. At calculation of mod. ($2^m$-1) in usual, values of N in binary notation may be all converted in order to change N into −N.

In fourth operation mode of $\beta^{-N}$, binary notation of the number of power N may be only converted. Consequently, if $\beta$ is supplied as input data E and $\alpha^o$ is supplied as input data A, F, B and converted number of power $\overline{N}$ as select signal $S_3$ is supplied from LSB in sequence, $\beta^{-N}$ can be obtained as output data P.

Fifth operation mode ($\beta^N \times \delta$, $\beta^{-N} \times \delta$) will be described. This is nearly identical to the second and third operation mode, and $\delta$ may be entered as input data B in place of $\alpha^o$.

Sixth operation mode ($\alpha^i$ x, $\alpha^{-i}$ x) will be described. In this case, $\alpha$ may be supplied as input data E and $\alpha^o$ be supplied as input data A and F and $\delta$ be supplied as input data B and further binary notation data of exponent i or -i be supplied from LSB in sequence.

As shown in Fig. 6, in order to mutually multiply elements on GF($2^4$) of vector expression, all components of one element in matrix expression (16 bits) may be entered from input terminal 131 in series to the shift register circuit, and components of 16 bits be multiplied with vector (b0, b1, b2, b3). In Fig. 6, each register of the shift register circuit is designated by suffix of each component of the matrix, and AND gates and EXOR gates to constitute the multiplication gate are designated by reference numerals identical to those in Fig. 3.

## Claims

1. An arithmetic circuit of finite field comprising:
   converting means (8—16, 22—24, 32—34, 42—44) for converting a first input of m-bits $a_0$—$a_3$), being a vector expression of elements of the finite field GF($2^m$) into components of a matrix expression in accordance with a generating polynomial (gi),
   multiplication means (61—64, 71—74, 81—84, 31—34) for multiplying each said component with a second input of m-bits ($b_0$—$b_3$) also being a vector of elements of the finite field GF($2^m$)), thereby to obtain a multiplication output ($c_0$—$c_3$) of said first and second inputs in the vector expression of the finite field GF($2^m$);
   characterised in that said converting means includes at least one input ($g_0$, $g_1$, $g_2$) for receiving input signals defining desired values of the coefficients of said generating polynomial; altering means (8—16) to alter the mode of operation of said converting means in accordance with those input signals so that the generating polynomial has the desired coefficients; in that said converting means includes shift register means which comprises a plurality of sets of exclusive-OR gates (22—24, 32—34, 42—44) which are

# EP 0 152 702 B1

connected in such manner that the outputs of the exclusive-OR gates in one set are respectively applied to one bit higher inputs of the exclusive-OR gates in the following set thereof, and that the MSB output of the exclusive-OR gates of the one set becomes the LSB input of the following set; in that said multiplying means comprises a plurality of AND gates (61—64, 71—74, 81—84, 91—94) in which each said component of matrix expression and each bit ($b_0$—$b_3$) of said second input are supplied; and in that said altering means comprises further AND gates (8—16) selectively connecting said MSB output of the exclusive-OR gate of the one set to the remaining inputs of the exclusive-OR gates of the following set under control of said input signals ($g_1$, $g_2$, $g_3$) to control the operation of said exclusive-OR gates thereby altering the generating polynomial of said converting means.

2. An arithmetic circuit according to claim 1, in which said converting means further comprises a clock pulse generator from which a clock pulse is supplied to said shift register means, so that a value stored in a said set of exclusive-OR gates is sequentially shifted in response to said clock signals.

3. An error code generation circuit incorporating an arithmetic circuit according to any one of the preceding claims for parity syndrome generation and/or error correction.

4. A data recording and/or reproducing apparatus incorporating an arithmetic circuit according to any one of claims 1 to 3 or an error code generation circuit according to claim 3.


## Patentansprüche

1. Rechenschaltung für ein finites Feld mit
einer Wandlereinrichtung (8—16, 22—24, 32—34, 42—44) zur Umwandlung eines ersten, einen Vektorausdruck von Elementen des finiten Feldes GF($2^m$) darstellenden m-Bit-Eingangssignals ($a_0$—$a_3$) in Komponenten eines Matrixausdrucks in Abhängigkeit von einem erzeugenden Polynom (gi),
und einer Multipliziereinrichtung (61—64, 71—74, 81—84, 91—94) zum Multiplizieren der einzelnen Komponenten des Matrixausdrucks mit einem zweiten, ebenfalls einen Vektor von Elementen des finiten Feldes GF($2^m$) darstellenden m-Bit-Eingangssignals ($b_0$—$b_3$) zur Bildung eines Multiplikations-Ausgangssignals ($c_0$—$c_3$) aus den ersten und zweiten Eingangssignalen in dem Vektorausdruck des finiten Feldes GF($2^m$),
dadurch gekennzeichnet,
daß die Wandlereinrichtung wenigstens einen Eingang ($g_0$, $g_1$, $g_2$) zur Aufnahme von Eingangssignalen aufweist, die gewünschte Werte der Koeffizienten der erzeugenden Polynoms bestimmen, ferner eine Änderungseinrichtung (8—16) zur Änderung der Funktion der Wandlereinrichtung in Abhängigkeit von den Ausgangssignalen in der Weise, daß das erzeugende Polynom die gewünschten Koeffizienten hat,
daß die Wandlereinrichtung eine Schieberegisteranordnung enthält, die mehrere Gruppen von EXKLUSIV-ODER-Gliedern (22—24, 32—34, 42—44) umfaßt, die so angeordnet sind, daß die Ausgangssignale der EXKLUSIV-ODER-Glieder einer Gruppe jeweils an den um ein Bit höheren Eingängen der EXKLUSIV-ODER-Glieder der folgenden Gruppe anliegen und das höchstwertige Ausgangssignal (MSB-Ausgangssignal) der EXKLUSIV-ODER-Glieder der einen Gruppe zum niedrigstwertigen Eingangssignal (LSB-Eingangssignal) der folgenden Gruppe wird,
daß die Multipliziereinrichtung eine Mehrzahl von UND-Gliedern (61—64, 71—74, 81—84, 91—94) aufweist, denen die einzelnen Komponenten des Matrixausdrucks und die einzelnen Bits ($b_0$—$b_3$) des zweiten Eingangssignal zugeführt werden,
und daß die Änderungseinrichtung weitere UND-Glieder (8—16) aufweist, die das genannte höchstwertige Ausgangssignal des EXKLUSIV-ODER-Glieds der einen Gruppe unter dem Steuereinfluß der genannten Eingangssignale ($g_0$, $g_1$, $g_2$) selektiv mit den verbleibenden Eingängen der folgenden Gruppe verbinden, um die Funktion der EXKLUSIV-ODER-Glieder zu steuern und dadurch das erzeugende Polynom der Wandlereinrichtung zu ändern.

2. Rechenschaltung nach Anspruch 1, bei der die Wandlereinrichtung ferner einen Taktimpulsgenerator aufweist, der die Schieberegisteranordnung in der Weise mit Taktimpulsen beaufschlagt, daß ein in einer Gruppe von EXKLUSIV-ODER-Gliedern gespeicherter Wert in Abhängigkeit von den Taktsignalen sequentiell verschoben wird.

3. Schaltung zur Erzeugung eines Fehlerkodes mit einer Rechenschaltung nach einem der vorhergehenden Ansprüche zur Erzeugung eines Paritätssyndroms und/oder zur Fehlerkorrektor.

4. Gerät zur Aufnahme und/oder Wiedergabe von Daten mit einer Rechenschaltung nach einem der Ansprüche 1 bis 3 oder einer Schaltung zur Erzeugung eines Fehlerkodes nach Anspruch 3.


## Revendications

1. Circuit arithmétique d'un champ fini comprenant:
un moyen convertisseur (8—16, 22—24, 32—34, 42—44) pour convertir un premier signal d'entrée de m bits ($a_0$—$a_3$), qui est une expression vectorielle d'éléments du champ fini GF($2^m$), en composantes d'une expression matricielle selon un polynôme générateur ($g_i$),
un moyen multiplicateur (61—64, 71—74, 81—84, 91—94) pour multiplier chaque composante par un deuxième signal d'entrée de m bits ($b_0$—$b_3$), qui est également un vecteur d'éléments du champ fini GF($2^m$), pour obtenir ainsi un signal de sortie de multiplication ($c_0$—$c_3$) des premier et deuxième signaux d'entrée

7

dans l'expression vectorielle du champ fini GF($2^m$);

caractérisé en ce que le moyen convertisseur comprend au moins une entrée ($g_0$, $g_1$, $g_2$) pour recevoir les signaux d'entrée définissant des valeurs voulues des coefficients du polynôme générateur; un moyen de modification (8—16) pour modifier le mode de fonctionnement du moyen convertisseur selon les signaux d'entrée pour que le polynôme générateur ait les coefficients voulus; en ce que le moyen convertisseur comprend un moyen à registres à décalage qui comprend un ensemble de groupes de portes OU-exclusif (22—24, 32—34, 42—44) qui sont connectées de telle manière que les signaux de sortie des portes OU-exclusif d'un groupe sont respectivement appliqués à des entrées d'un bit de poids plus fort des portes OU-exclusif dans le groupe suivant de cet ensemble, et en ce que la sortie du bit de poids le plus fort MSB des portes OU-exclusif du groupe devient l'entrée du bit de poids de plus faible LSB du groupe suivant; en ce que le moyen multiplicateur comprend un ensemble de portes ET (61—64, 71—74, 81—84, 91—94) dans lesquelles chaque composante de l'expression matricielle et chaque bit ($b_0$—$b_3$) du deuxième signal d'entrée sont fournis; et en ce que le moyen de modification comprend en outre des portes ET (8—16) connectant sélectivement la sortie de bit MSB des portes OU-exclusif du groupe aux autres entrées des portes OU-exclusif du groupe suivant sous la commande des signaux d'entrée ($g_1$, $g_2$, $g_3$) pour commander le fonctionnement des portes OU-exclusif afin de modifier ainsi le polynôme générateur du moyen convertisseur.

2. Circuit arithmétique selon la revendication 1, dans lequel le moyen convertisseur comprend en outre un générateur d'impulsions d'horloge qui fournit une impulsion d'horloge au moyen à registres à décalage, de sorte qu'une valeur mémorisée dans un groupe de portes OU-exclusif est décalée séquentiellement en réponse aux signaux d'horloge.

3. Circuit générateur de code d'erreur incorporant un circuit arithmétique selon l'une quelconque des revendications 1 et 2, pour la génération d'un syndrome de parité et/ou une correction d'erreur.

4. Dispositif d'enregistrement et/ou de reproduction de données incorporant un circuit arithmétique selon l'une quelconque des revendications 1 à 3 ou un circuit générateur de code d'erreur selon la revendication 3.

# F I G. 1

# F I G. 2

1

FIG. 3

# FIG. 4

FIG. 5

FIG. 6

EP 0 152 702 B1